Europäisches Patentamt

European Patent Office

Office européen des brevets

(19)

(11) Veröffentlichungsnummer: **0 043 385**
**B1**

(12) **EUROPÄISCHE PATENTSCHRIFT**

(45) Veröffentlichungstag der Patentschrift: **09.10.85**

(51) Int. Cl.⁴: **H 05 K 7/14**, H 01 R 23/68

(21) Anmeldenummer: **80200647.8**

(22) Anmeldetag: **04.07.80**

(54) **Steckeinheit.**

(43) Veröffentlichungstag der Anmeldung:
**13.01.82 Patentblatt 82/02**

(45) Bekanntmachung des Hinweises auf die
Patenterteilung:
**09.10.85 Patentblatt 85/41**

(84) Benannte Vertragsstaaten:
**AT CH DE LI NL SE**

(56) Entgegenhaltungen:
**DE-A-2 810 572**
**DE-A-2 942 293**

(73) Patentinhaber: **BBC Aktiengesellschaft Brown,
Boveri & Cie.
Haselstrasse
CH-5401 Baden (CH)**

(72) Erfinder: **Henle, Burkhard
Waldmatt 4
CH-5242 Birr AG (CH)**
Erfinder: **Müller, Bernhard
Schulstrasse 7
CH-5442 Fislisbach AG (CH)**

Courier Press, Leamington Spa, England.

EP 0 043 385 B1

## Beschreibung

Bei der Erfindung wird ausgegangen von einer Steckeinheit nach dem Oberbegriff des Patentanspruchs 1.

Mit diesem Oberbegriff nimmt die Erfindung auf einen Stand der Technik von Steckeinheiten Bezug, wie er in der DE—A1—2 942 293 beschrieben ist. Dort werden mit Kontaktstiften versehene Kontaktvorrichtungen, die mittels einer Frontplatte mit einer Steckeinheit zur Aufnahme elektrischer Komponenten verbunden sind, so ausgebildet, dass zur Erleichterung des Herausziehens der Steckeinheit aus einem Baurahmen für unterschiedliche Gruppen von Kontaktvorrichtungen ein unterschiedliches Spiel in Ausziehrichtung besteht. Dabei tritt beim Einschieben der Steckeinheit in der Baurahmen keine Erleichterung eine; die Einsteckkraft wird durch Schrauben aufgebracht. Eine vorgebbare Reihenfolge beim Herstellen der Steckverbindungen beim Einschieben ist nicht gewährleistet.

Bekanntlich finden in verschiedensten Maschinen und Anlagen in vermehrtem Masse elektronische Steuerungs- und Regeleinrichtungen Verwendung. Allgemein hat sich hierfür aus Gründen der Servicefreundlichkeit der modulare Aufbau mittels austauschbarer Baugruppenträger bewährt. Dabei stellt sich des Problem, auf einfache Weise möglichst einwandfreie mechanische und elektrische Verbindungen der Baugruppenträger mit einem meist grösseren Appartegehäuse zu schaffen, welche den hohen Sicherheitsanforderungen genügen. Anwendung finden hierfür Baugruppenträger mit Verriegelungsvorrichtungen (vgl. DE—OS 28 10 572) sowie Ein- und Ausziehvorrichtungen (z.B. DE—OS 28 14 991).

In der Praxis kommt es jedoch häufig vor, dass insbesondere komplexe Anlagen nicht oder nur unter Einbezug eines hohen Sicherheitsrisikos abgeschaltet werden können. Dies bedingt ein Austauschen von beispielsweise, defekten oder der Wartung zuzuführenden Baugruppenträgern während des Betriebes. Nun bestehen jedoch häufig Verknüpfungen im Signalfluss und/oder der Speisung der einzelnen Baugruppenträger untereinander oder zu zentralen Einheiten. Daraus ergibt sich die Forderung, dass Baugruppenträger nicht oder nur erst nach Abschaltung oder Zuschaltung von Speisespannungen und/oder Signalquellen entfernt bzw. eingebaut werden dürfen. Grundsätzlich besteht hierfür die Möglichkeit, logische Verknüpfungsschaltungen vorzusehen, welche jedoch den schaltungstechnischen Aufwand derartiger Anlagen erhöhen und zudem selbst wieder zu Betriebsstörungen führen können.

Die Erfindung, wie sie im Patentanspruch 1 definiert ist, löst die Aufgabe, eine Steckeinheit anzugeben, die ein stufenweises Zuschalten oder Kurzschliessen von Steckerverbindungen ermöglicht.

Der Vorteil der Erfindung besteht darin, dass der Einschubvorgang der in den Baugruppenträger selbsttätig das stufenweise Herstellen der Steckverbindung bewirkt. Beim Herausziehen der Steckeinheit wird die gestufte Position zwangsläufig wiederhergestellt.

Die Ausgestaltung nach Anspruch 2 gewährleistet eine präzise Steuerung des Verriegelungs- bzw. Entriegelungsvorgangs.

Die Weiterbildung nach Anspruch 3 erlaubt den Einbau einer zuverlässig arbeitenden Verriegelungsvorrichtung auch bei beschränkten Raumverhältnissen.

Nachfolgend wird anhand von Zeichnungen ein bevorzugtes Ausführungsbeispiel einer in zwei Stufen zusammengeschalteten Steckerverbindung in einem Leiterplattenmagazin dargestellt.

Dabei zeigen

Fig. 1 einen Baugruppenträger mit zwei fest angeordneten Steckerelemente und einem auf einem axialverschiebbaren Steckerträger angebrachten weiteren Steckerelement und

Fig. 2 eine schematische Prinzipdarstellung des axialverschiebbaren Steckerträgers gemäss Fig. 1 mit zugehöriger Kulisse.

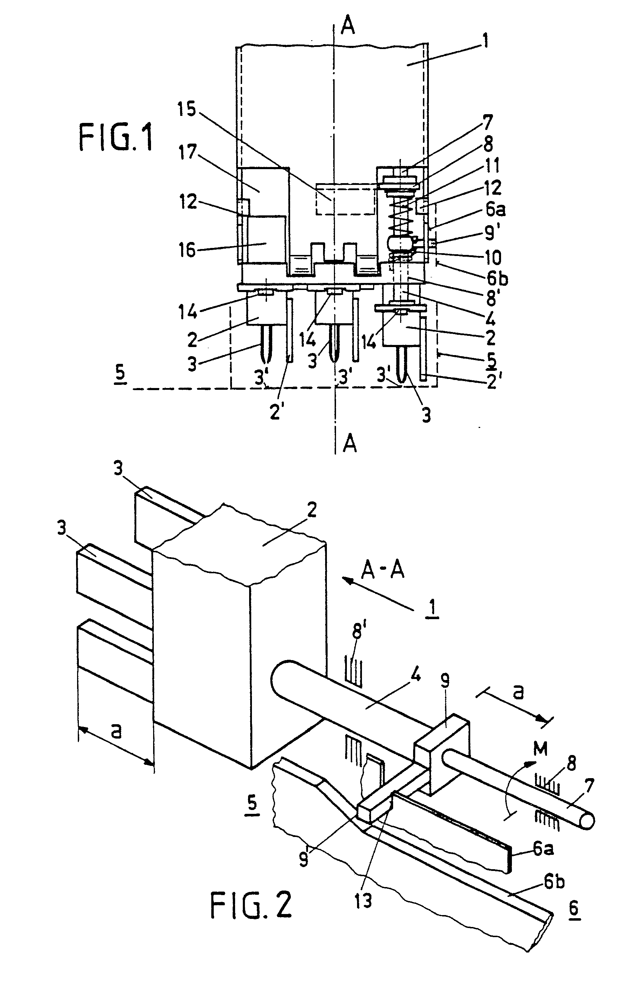

In Fig. 1 ist eine Baugruppenträger bzw. eine Steckeinheit mit 1 bezeichnet. Stirnseitig sind in bekannter Weise zwei Stecker 2 angeordnet, während ein dritter an sich identischer Stecker 2 auf einem Steckerträger 4 axialverschiebbar angeordnet ist. Sämtliche Stecker weisen erste Steckerelemente 3 auf, welche in einem durch gestrichelte Linien symbolisch dargestellten Leiterplattenmagazin 5 in zweite, nur hinsichtlich ihrer Position angedeutete Steckerelemente 3' eingeschoben werden.

Fig. 1 zeigt den Zustand, bei welchem die Steckerelemente 3 des axialverschiebbaren Steckerträgers 4 mit den hierzu korrespondierenden zweiten Steckerelementen 3' in Kontakt stehen, während die sich daneben befindenden ersten und zweiten Steckerelemente 3 bzw. 3' miteinander noch nicht in elektrischem Kontakt sind. Durch ein weiteres Einschieben des Baugruppenträgers 1 in Achsrichtung A—A in das Leiterplattenmagazin 5 treten sämtliche ersten und zweiten Steckerelemente 3, 3' in eine elektrische Verbindung. Hierbei wird gleichzeitig der Steckerträger 4 zurückgeschoben, so dass nach einem stufenweisen Einschalten des Baugruppenträgers 1 im Leiterplattenmagazin 5 dieser in seiner üblichen Funktionslage voll zugeschaltet und funktionsfähig ist.

Aus der Prinzipdarstellung, Fig. 2, ist wiederum der Steckerträger 4 ersichtlich, auf welchem sich ein Stecker 2 mit ersten Steckerelementen 3 befindet, welche eine Kontaktlänge a aufweisen und in nicht näher dargestellte zweite Steckerelement 3' eingeschoben sind.

Der Steckerträger 4, im wesentlichen ein Hülse, weist an einer Endseite einen Drehriegel 9 auf, in welchen eine Welle 7 drehgesichert eingesetzt ist. Der Steckerträger 4 und die Welle 7 sind in Lagern 8', bzw. 8 geführt. Ein Hebel 9' des Drehriegels 9 ist in einer Kulisse 6 geführt; dabei ist der Hebel 9' in einer Nut 13 einer inneren Platte 6a eingerastet.

Das überragende Endteil des Hebels 9' liegt hier auf dem Schrägteil einer äusseren, rampenförmigen Platte 6b auf, welche sich im Leiterplattenmagazin (Chassis) befindet.

Wird nun der Baugruppenträger 1 weiter in Achsrichtung A—A in das leiterplattenmagazin eingeschoben, so bleiben die zuerst zusammengefügten Steckerelemente 3, 3' miteinander verbunden, während gleichzeitig der Hebel 9' durch die äussere rampenförmige Platte 6b aus seiner Rasterung in der inneren Platte 6a in Pfeilrichtung M herausgedreht wird. Dies bewirkt beim weiteren Einschieben des Baugruppenträgers 1 ein Axialverschieben des Steckerträgers 4 entgegen der Einschubrichtung, wodurch die nicht dargestellten, daneben befindlichen festmontierten Steckerelemente miteinander verbunden werden. Bei an sich identisch Steckerelemente entspricht somit dieses Axialverschieben der Kontaktlänge a.

Weitere Einzelheiten der realisierten Konstruktion sind aus Fig. 1 ersichtlich, wo gleiche Funktionsteile wie bei Fig. 2 mit gleichen Bezugsziffern versehen sind.

Zum erleichterten Zusammenfügen der Steckerelemente 3 und 3' sind hier Fuhrungsplatten 2' vorgesehen. Die innere Platte 6a ist Bestandteil des Baugruppenträgers 1, in welchen eine schlitzartige Ausnehmung für den Hebel 9' eingearbeitet ist. Damit der Hebel 9' definiert in der Kulisse 6 gleitet — und präzise ein- und ausrastet — ist eine Torsionsfeder 10 vorhanden, welche den Hebel in Richtung der Kulissenoberfläche drückt. Eine Druckfeder 11 befindet sich auf der Welle 7 und stützt sich am hinteren Lager 8 ab; sie dient zur Überwindung von Reibkräften in den Lagern 8, 8' und der Kulisse 6, so dass beim Herausziehen des Baugruppenträgers 1 aus dem Leiterplattenmagazin 5 in jedem Fall der axialverschiebbare Steckerträger 4 in seine vorgeschobene Endstellung gedrückt wird.

Im weiteren dient ein Anschlag 12 zur rückwärtigen Wegbegrenzung des Steckerträgers 4; das vordere Lager 8' besteht aus einer in das Blech des Baugruppenträgers eingepressten Büchse, während das hintere Lage 8 auf einem Support 15 ruht.

Die Stecker 2 sind in üblicher Weise endseitig mittels Schrauben 14 montiert und mit Kabelanschlüssen 16 versehen. Aussparungen 17 dienen der erliechterten Montage.

Grundsätzlich genügt es, einen Steckerträger 4 mit Drehriegel 9 und Kulisse 6 an einer Endseite des Steckers 2 vorzusehen. Die andere Endseite könnte als eine vereinfachte Parallelführung, z.B. durch einen in einer Lagerbüchse geführten Bolzen ausgeführt sein.

Aus Toleranz- und Stabilitätsgründen empfiehlt es sich jedoch, auf beiden Endseiten Drehriegel mit Kulissen vorzusehen.

Die erfindungsgemässen Steckerträger haben sich insbesondere in der Schutztechnik bewährt, wo beispielsweise Signalleitungen (zu Mess-Stel-len etc.) als erste zugeschaltet und als letzte Verbindungen abgeschaltet werden, oder wo mit dem Einschubvorgang eines Baugruppenträgers eine Umschaltung der Geräte-Speisung (z.B. über Relais) zu Prüfeinrichtungen etc. erfolgen muss.

Bezeichnungsliste

    1 = Baugruppenträger
    2 = Stecker
    2' = Führungsplatten
    3 = Erste Steckerelemente
    3' = Zweite Steckerelemente
    4 =   Steckerträger
    5 =   Leiterplattenmagazin
    6 = Kulisse
   6a = innere Platte
   6b = äussere, rampenförmige Platte
    7 = Welle
 8, 8' = Lager
    9 = Drehriegel
   9' = Hebel von 9
  10 = Torsionsfeder
  11 = Druckfeder
  12 = Anschlag
  13 = Nut
  14 = Schrauben
  15 = Support
  16 = Kabelanschlüsse
  17 = Aussparung
A—A = Achsrichtung
    a = Kontaktlänge

**Patentansprüche**

1. Steckeinheit
a) mit mindestens zwei Steckerlementen (3),
b) die an der Stirnseite einer Baugruppe (1) oder einer Leiterplatte angeordnet sind, und gemeinsam in zueinander paralleler Richtung ausziehbar oder einschiebbar sind,
c) wobei mindestens ein Steckerelement (3) an einem beweglichen Steckerträger (4) angebracht ist,
d) welcher bezüglich der Baugruppe oder Leiterplatte längs eines vorgebbaren, begrenzten Weges (a) axial verschiebbar und
e) der in wenigstens einer Endstellung festlegbar ausgestaltet ist,
dadurch gekennzeichnet,
f) dass der bewegliche Steckerträger (4) einen Drehriegel (9) mit einem Hebel (9') zum Eingriff in mindestens eine Verriegelungseinrichtung (6a) und zur Drehverriegelung des beweglichen Steckerträgers in mindestens einer Endstellung aufweist und
g) dass dieser Hebel beim Einschieben der Steckeinheit in einen Baugruppenträger oder in ein Leiterplattenmagazin sowie beim Herausziehen mit einer Kulisse (6) zum Entriegeln in Verbindung bringbar ist.

2. Steckeinheit nach Anspruch 1, dadurch gekennzeichnet, dass der Hebel (9') des Drehriegels (9) mit einer in Richtung der Oberfläche der Kulisse (6) drückenden Torsionsfeder (10) in Wirkverbindung ist.

3. Steckeinheit nach Anspruch 1 oder 2, da-

durch gekennzeichnet, dass die Verriegelungsein-richtung aus einer inneren Platte (6a) mit wenigstens einem Anschlag (12) und/oder einer dem Hebel (9') des Drehriegels (9) angepassten Nut (13) besteht.

4. Steckeinheit nach einem der vorhergehenden Ansprüche, dadurch gekennzeichnet, dass mindestens zu einem Steckerelement (3) eine Führungselement (2') vorgesehen ist.

**Revendications**

1. Bloc interchangeable,
   a) avec au moins deux éléments de fiche (3),
   b) qui sont disposés à la face frontale d'un ensemble de montage (1) ou d'une plaquette de conducteurs et peuvent être retirés ou introduits ensemble, parallèlement l'un à l'autre,
   c) au moins un élément de fiche (3) étant adapté à un porte-fiche (4) mobile,
   d) qui peut coulisser axialement le long d'une trajectoire (a) limitée préréglable, par rapport à l'ensemble de montage ou à la plaquette de conducteurs, et
   e) qui est constitué de façon à pouvoir être bloqué dans au moins une position de fin de course,
   caractérisé en ce que
   f) le porte-fiche (4) mobile comporte un verrou rotatif (9) pourvu d'un levier (9') destiné à s'engager dans au moins un dispositif de verrouillage (6a) et à assurer le verrouillage rotatif du porte-fiche mobile dans au moins une position de fin de course, et que
   g) ce levier peut être mis en contact avec une coulisse (6) de déverrouillage lors de l'enfichage du bloc interchangeable dans un support d'éléments de montage ou dans un magasin à plaquettes de conducteurs.

2. Bloc interchangeable suivant la revendication 1, caractérisé en ce que le levier (9') du verrou rotatif (9) se trouve en relation active avec un ressort de torsion (10) appuyant en direction de la surface de la coulisse (6).

3. Bloc interchangeable suivant le revendication 1 ou 2, caractérisé en ce que le dispositif de verrouillage se compose d'une plaque interne (6a) avec au moins une butée (12) et/ou d'une encoche (13) adaptée au levier (9') du verrou rotatif (9).

4. Bloc interchangeable suivant l'une des revendications précédentes, caractérisé en ce qu'un élément de guidage (2') est prévu à au moins un des éléments de fiche (3).

**Claims**

1. Plug-in unit
   a) with at least two plug elements (3),
   b) which are arranged on the end face of a sub-assembly (1) or a circuit board and can be pulled out or pushed in relative to one another in a parallel direction,
   c) with at least one plug element (3) being attached to a movable plug carrier (4),
   d) which can be axially displaced relative to the sub-assembly or circuit board along a predeterminable, limited path (a) and
   e) which is shaped in such a way that it can be fixed in at least one end position,
   characterised in that
   f) the movable plug carrier (4) has a rotary lock (9) with a lever (9') for engaging in at least one locking device (6a) and for rotary locking of the movable plug carrier in at least one end position, and
   g) this lever, when the plug unit is pushed into a sub-assembly carrier or into a circuit board magazine and when it is pulled out, can be brought into contact with a connecting link (6) for the purposes of unlocking.

2. Plug-in unit according to claim 1, characterised in that the lever (9') of the rotary lock (9) is in-operative connection with a torsion spring (10) pressing in the direction of the surface of the connecting link (6).

3. Plug-in unit according to claim 1 or 2, characterised in that the locking device consists of an inner plate (6a) having at least one stop (12) and/or a groove (13) adapted to the lever (9') of the rotary lock (9).

4. Plug-in unit according to one of the preceding claims, characterised in that a guide element (2') is provided for at least one plug element (3).

FIG.1

FIG.2